# EUROPÄISCHE PATENTSCHRIFT

(11) **EP 0 484 576 B1**
(45) Veröffentlichungstag und Bekanntmachung des Hinweises auf die Patenterteilung: **02.05.1997**
(21) Anmeldenummer: 90121285.2
(22) Anmeldetag: 07.11.1990
(51) Int. Cl.: G06J 1/00, G06G 7/22, H03M 1/00

(54) **Vorrichtung zur Unterteilung von analogen periodischen Signalen**
Device for subdividing periodical analog signals
Dispositif de subdivision de signaux périodiques analogiques

(43) Veröffentlichungstag der Anmeldung: 13.05.1992
(73) Patentinhaber: Dr. Johannes Heidenhain GmbH, D-83292 Traunreut (DE)
(72) Erfinder: Kranitzky, Walter, Dr., W-8220 Traunstein (DE); Wastlhuber, Robert, Dipl.-Ing. (FH), W-8268 Garching/Alz (DE)

(56) Entgegenhaltungen:
- FR-A- 1 585 016
- FR-A- 2 209 147
- US-A- 3 512 151
- US-A- 4 346 447

## Beschreibung

Die Erfindung bezieht sich auf eine Vorrichtung zur Unterteilung von analogen periodischen Signalen nach dem Oberbegriff des Anspruches 1.

Derartige - auch als Interpolatoren bezeichnete - Vorrichtungen sind aus einer Vielzahl von Druckschriften bekannt. So wird zum Beispiel in der DE-OS 27 29 697 eine Interpolationseinrichtung beschrieben, bei der mit Hilfe eines Digitalrechners aus den digitalisierten Momentanwerten zweier um 90° elektrisch zueinander phasenverschobenen Sinus- und Cosinussignale der jeweilige Zwischenwert errechnet wird.

Ein anderes Beispiel ist aus der EP-A2 0 213 904 bekannt. Dort sind Zwischenwerte vorab in einem arctan-Speicher abgespeichert. Die entsprechenden Zwischenwerte werden durch binäre Signalkombinationen der Sinus- und Cosinussignale - die Adressen für den Speicher bilden - auf dessen Ausgänge geschaltet.

Diese Beispiele sollen zeigen, daß Zwischenwerte auf vielfältige Weise erzeugt, z.B. errechnet werden können (diese Methode ist verhältnismäßig langsam), oder aber vorab abgespeichert sind und aktuell ausgelesen werden (diese Methode braucht verhältnismäßig viel Speicherplatz).

Der Erfindung liegt die Aufgabe zugrunde, eine weitere Unterteilungsmöglichkeit zu schaffen, die eine hohe Unterteilungsgeschwindigkeit erlaubt und bei hohem Unterteilungsfaktor wenig Speicherplatz benötigt.

Diese Aufgabe wird durch eine Vorrichtung mit den Merkmalen des Anspruches 1 gelöst.

Vorteilhafte Ausgestaltungen der Erfindung sind in den Unteransprüchen angegeben.

Gegenüber dem Stand der Technik bietet die Erfindung unter anderem die Vorteile, daß nur ein verhältnismäßig geringer Schaltungsaufwand erforderlich ist, der sich zudem gut in integrierter Bauweise realisieren läßt. Auch der Speicheraufwand ist trotz hoher Interpolationsfähigkeit sehr gering. Die Unterteilungsgeschwindigkeit ist hoch und es können bei den Zwischenwerten sowohl die Phasenlage als auch die Amplitude ermittelt werden.

Mit Hilfe der Zeichnungen soll ein Ausführungsbeispiel und dessen Wirkungsweise näher erläutert werden.

Es zeigt
- Figur 1: ein Blockschaltbild eines Interpolators;
- Figur 2A bis 2F: Kreisdiagramme,
- Figur 3: ein Blockschaltbild eines Bausteines aus dem Blockschaltbild gemäß Figur 1.

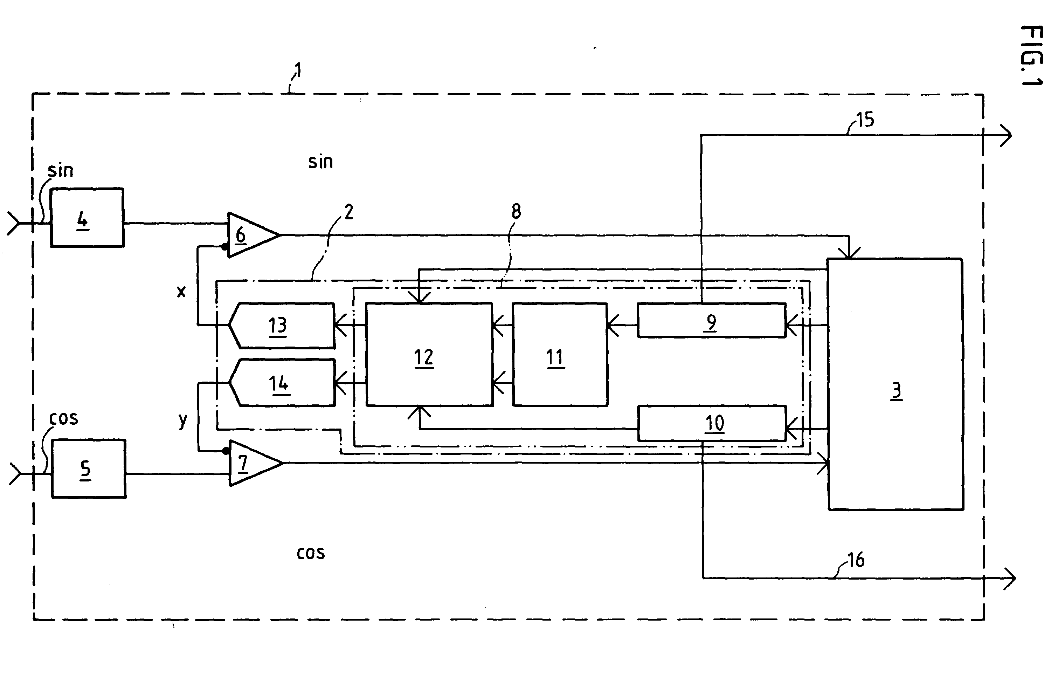

Das in Figur 1 gezeigte Blockschaltbild stellt einen Interpolator 1 für annähernd sinusförmige Abtastsignale einer inkrementalen Längen- oder Winkelmeßeinrichtung dar. Da diese Abtastsignale zueinander um 90° phasenverschoben sind, können sie als sin- und cos- Signale betrachtet werden.

Aufgabe eines Interpolators ist es, diese periodischen Signale zu verarbeiten. Entspricht die Kurvenform eines Signals - wie hier - einer trigonometrischen Funktion so ist es üblich, eine Periode in Grad-Einheiten zu unterteilen. Diese Rasterung einer Periode in beliebige Winkelbruchstücke soll ein Interpolator statisch, dynamisch sowie mit unterschiedlichen Amplituden des Signals, vornehmen.

Der im folgenden beschriebene Interpolator ermittelt aus den zwei um 90° phasenversetzten Meßsignalen sin und cos den Winkel innerhalb einer Periode sowie wie die Amplitude.

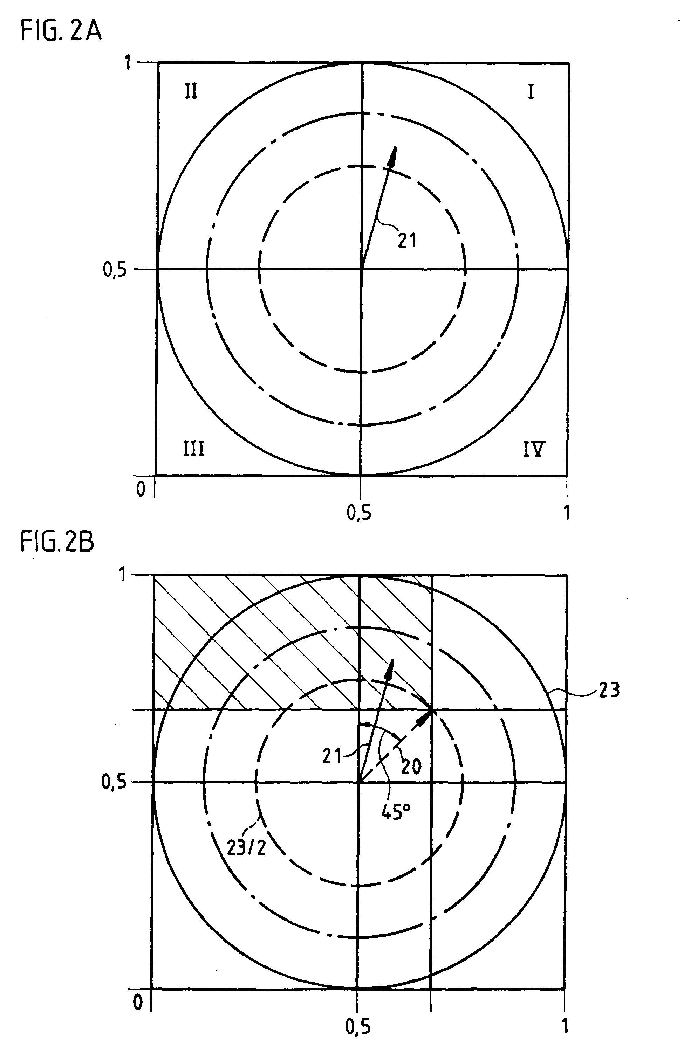

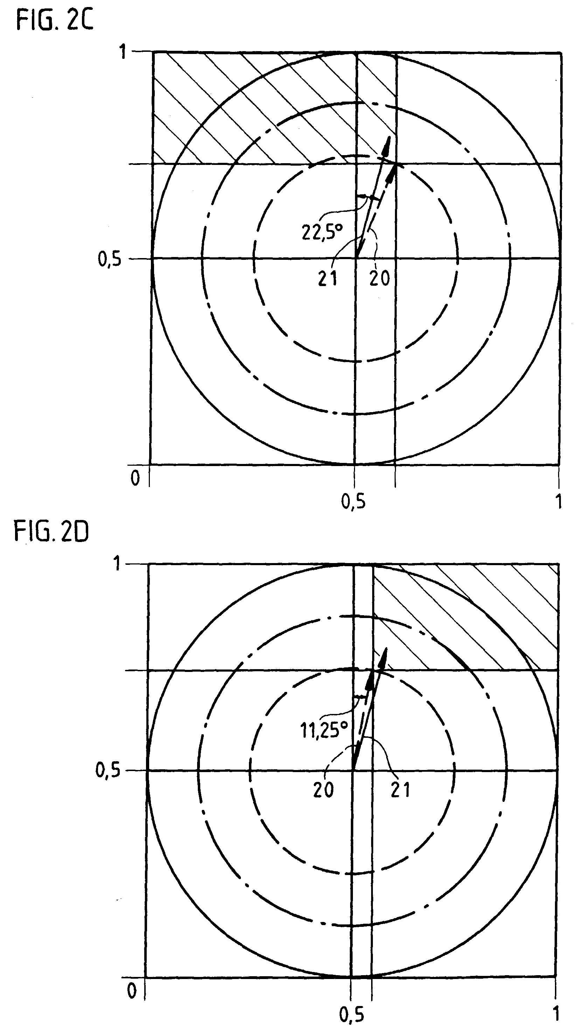

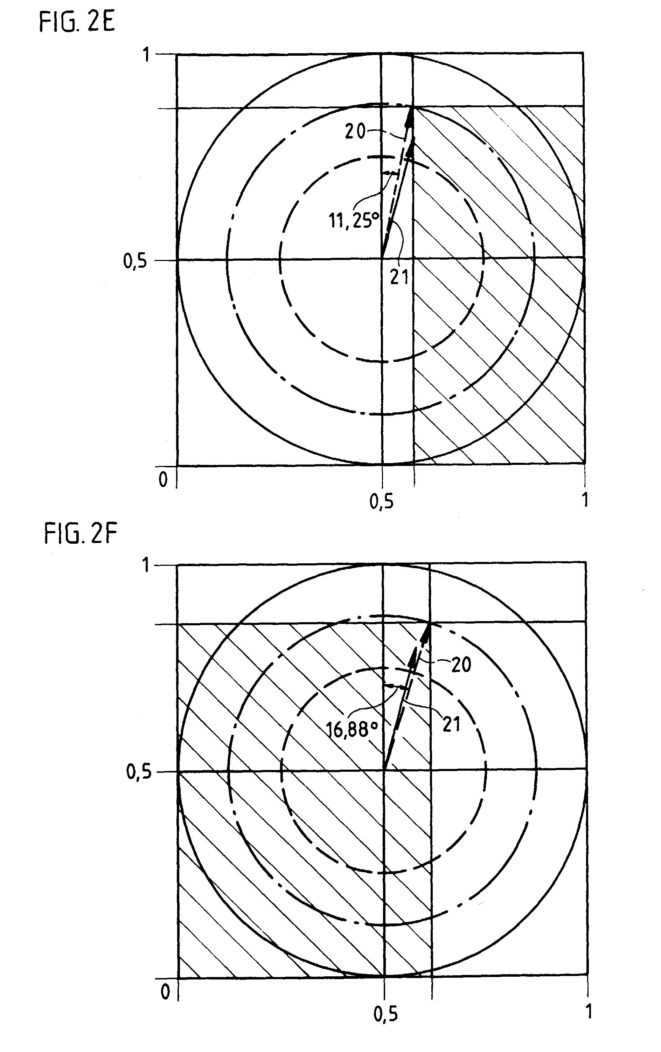

Durch die Signale sin und cos wird ein Momentan-Vektor aufgespannt, wie anhand von Figur 2 noch erläutert werden wird. Der Interpolator 1 weist einen Vektor-Generator 2 auf, der synthetisch einen Vergleichs-Vektor erzeugen kann, der nach Winkel und Betrag veränderbar ist.

Eine Steuerlogik 3 wirkt auf den Vektor-Generator 2 ein und nähert mittels eines Algorithmus den Vergleichs-Vektor dem Momentan-Vektor schrittweise an, bis eine ausreichende Genauigkeit vorliegt. Die Annäherung eines Wertes an einen anderen Wert ist unter dem Fachausdruck "sukzessive Approximation" an sich bekannt.

Bei der vorliegenden Erfindung erfolgt jedoch die Annäherung nicht in Abhängigkeit von einer einzigen Größe, wie dies in A/D-Wandlern geschieht, sondern gleichzeitig in Abhängigkeit von Winkel- und Betrags-Vergleichswerten.

Die analogen periodischen Meßsignale sin und cos werden in Sample & Hold-Gliedern 4 und 5 vor jedem Verarbeitungszyklus zwischengespeichert. Die eingespeicherten Analogwerte werden in ihrem Signalzweig jeweils einem Komparator 6 und 7 zugeführt.

Im Vektor-Generator 2 ist eine Logikschaltung 8 vorgesehen, die aus Winkelregister 9, Betragsregister 10, Wertetabelle 11 (Sinus-Cosinus Tabelle) und einem Betragsteller 12 besteht. Der Vektorgenerator 2 weist außerdem noch zwei Digital-/Analog-Wandler 13 und 14 auf, die von der Logik 8 angesteuert werden. Die Digital-/Analog-Wandler 13 und 14 liefern Referenzspannungen für die Komparatoren 6 und 7 in dem die Analogwerte der Meßsignale sin und cos mit diesen Referenzspannungen verglichen werden. Die analogen Referenzspannungen am Ausgang der Digital-/Analog-Wandler 13 und 14 entsprechen den von der Logik 8 erzeugten Digital-Werten für Winkel und Betrag des Vergleichs-Vektors. Die Logik 8 wandelt digitale Werte für Winkel und Betrag des Vergleichs-Vektors in die entsprechenden Sinus- und Cosinuswerte um. Die dafür erforderliche Wertetabelle 11 enthält die notwendigen Sinus- und Cosinuswerte. Für die Realisierung ist Speicherplatz für die Sinus- und Cosinuswerte eines Viertelkreises der halben möglichen Maximalamplitude ausreichend, was sich günstig auf die erforderliche Speichergröße auswirkt. Die Winkelauflösung der Tabelle sollte um den Faktor zwei höher sein als die Auflösung der D/A-Wandler.

Die Vergleichsergebnisse der Analogwerte von Momentan- und Vergleichs-Vektor werden von den Komparatoren 6 und 7 in die Steuerlogik 3 eingespeist. Diese Steuerlogik 3 beaufschlagt dann das Winkelregister 9 welches auf einer Ausgangsleitung 15 einen Interpolationswert liefert. Ferner wird über das Betragregister 10 der Betragsteller 12 angesteuert und über eine Leitung 16 der Amplitudenwert ausgegeben. Der Betragsteller 12 bekommt von der Steuerlogik 3 außerdem Informationen zur Quadrantenerkennung.

Ein in den Figuren 2A bis 2F dargestelltes Kreis-Diagramm zeigt verschiedene Stadien der Annäherung eines Vergleichs-Vektors 20 an einen hier willkürlich plazierten Momentan-Vektor 21. Ein Kreis-Diagramm eignet sich besonders gut für die Veranschaulichung der hier zu erläuternden Verhältnisse, da die Meßsignale einer trigonomischen Funktion entsprechen. Eine Periode der Meßsignale sin und cos wird durch einen vollständigen Kreis dargestellt, der entgegen dem Uhrzeigersinn in die Quadranten I, II, III und IV aufgeteilt ist. Die Unterteilung in beliebige Winkelbruchteile erfolgt mit dem schon beschriebenen Interpolator 1.

Der im ersten Quadranten I befindliche Momentan-Vektor 21 soll approximativ ermittelt werden. Dazu wird vom Vektor-Generator 2 ein Vergleichs-Vektor 20 erzeugt, der sich bevorzugt auf der Winkelhalbierenden des Quadranten I mit der Hälfte der Maximalamplitude befindet. Die Maximalamplitude ist durch einen Vollkreis mit dem Bezugszeichen 23 dargestellt, die Hälfte der Maximalamplitude dementsprechend durch einen gestrichelt dargestellten Kreis mit dem Bezugszeichen 23/2. Die Ausgangslage des Vergleichs-Vektors 20 ist vorteilhaft, weil aus dieser Position heraus die Wahrscheinlichkeit am größten ist, in einer minimalen Anzahl von Schritten den Momentan-Vektor 21 zu ermitteln. Prinzipiell ist jedoch die Ausgangswinkelposition und der Betrag des Vergleichs-Vektors 20 beliebig zu wählen. Die analogen Werte des Vergleichs-Vektors 20 liefern die Referenzspannungen für die Komparatoren 6 und 7 (Figur 1) an denen auch die analogen Momentanwerte der Abtastsignale sin und cos liegen, die ja den Momentan-Vektor 21 aufspannen.

Der Vergleich in den Komparatoren 6 und 7 gibt entweder Aufschluß über zu großen oder zu kleinen Betrag des Vergleichs-Vektors 20 oder über zu großen oder zu kleinen Phasenwinkel des Vergleichs-Vektors 20. Diese Aussage wird durch logische Signalzustände getroffen, die an den Ausgängen der Komparatoren 6 und 7 vergleichsabhängig anstehen.

Anhand der Figuren 2B bis 2F soll dies deutlich gemacht werden. Mit Hilfe des Vergleichs-Vektors 20 wird nach Art eines Koordinatenkreuzes, dessen Ursprung die Spitze des Vergleichs-Vektors 20 ist, eine Feldaufteilung vorgenommen, so daß sich vier Felder ergeben. In den Feldern gelten gewisse Korrekturbedingungen für die Annäherung des Vergleichs-Vektors 20 an den Momentan-Vektor 21.

Wenn sich die Spitze des Momentan-Vektors 21 in dem Feld "links oben" vom Ursprung des durch den Vergleichs-Vektor 20 gebildeten Koordinatensystems befindet, so muß der Winkel des Vergleichs-Vektors 20 in positiver Richtung korrigiert werden. Befindet sich die Spitze des Momentan-Vektors 21 im Feld "rechts oben", so muß der Betrag des Vergleichs-Vektors 20 positiv korrigiert werden. Befindet sich die Spitze des Momentan-Vektors 21 im Feld "links unten", so muß der Betrag des Vergleichs-Vektors 20 negativ korrigiert werden und befindet sich schließlich die Spitze des Momentan-Vektors 21 im Feld "rechts unten", so muß der Winkel des Vergleichs-Vektors 20 negativ korrigiert werden.

Die vorstehenden Bedingungen sind in der nachfolgenden Tabelle angegeben, wobei das Kreuz das durch den Vergleichs-Vektor 20 gebildete Koordinatensystem darstellt, dessen Ursprung die Spitze des jeweiligen Vergleichs-Vektors 20 ist:

| | |
|---|---|
| Winkelkorrektur + | Betragkorrektur + |
| Betragkorrektur - | Winkelkorrektur - |

Gemäß Figur 2B befindet sich die Spitze des Momentan-Vektors 21 im Feld "links oben" - das schraffiert dargestellt ist -, also muß der Winkel des Vergleichs-Vektors 20 um einen Annäherungsschritt positiv korrigiert werden (siehe Tabelle).

Gemäß der Erfindung wird für den Korrekturschritt immer die Hälfte des vorangegangenen Korrekturschrittes verwendet. Für Figur 2B gilt sinngemäß das Gleiche, obwohl noch kein Korrekturschritt vorangegangen ist. Da aber willkürlich ein Winkel von 45° gewählt wurde, beträgt der Korrekturschritt von diesem Wert die Hälfte, also 22,5°.

In Figur 2C ist dieser Schritt dargestellt. Der Vergleichs-Vektor 20 befindet sich nun mit unverändertem Betrag unter 22,5° im ursprünglichen Koordinatensystem. Der Momentan-Vektor 21 befindet sich wieder im Feld "oben links" des neuen, durch den Vergleichs-Vektor 20 gebildeten Koordinatensystems, das auch als Unter-Koordinatensystem bezeichnet werden kann. Für den gezeigten Fall gilt ersichtlich die gleiche Korrekturbedingung: "Winkelkorrektur positiv". Das bedeutet, einen Korrekturschritt mit der Hälfte des vorangegangenen Korrekturwertes in positive Richtung.

In Figur 2D ist diese Situation gezeigt und der Vergleichs-Vektor 20 befindet sich mit immer noch unverändertem Betrag unter einem Winkel von 11,25° im ursprünglichen Koordinatensystem. Nun liegt die Spitze des Momentan-Vektors im Feld "rechts oben" des neuen Unter-Koordinatensystemes. Bei dieser Situation gilt die Korrekturbedingung: "Betragskorrektur positiv". Grundbetrag des Vergleichs-Vektors 20 war die Hälfte der Maximalamplitude, der neue Betrag des Vergleichs-Vektors 20 ist dementsprechend Dreiviertel der Maximalamplitude.

In Figur 2E ist diese Situation gezeigt. Der Vergleichs-Vektor 20 befindet sich weiter unter einem Winkel von 11,25° im ursprünglichen Koordinatensystem, sein Betrag hat sich aber um die Hälfte auf Dreiviertel der Maximalamplitude erhöht. Das dadurch entstandene neue Unter-Koordinatensystem zeigt, daß sich die Spitze des Momentan-Vektors 21 gerade noch im Feld "rechts unten" befindet, so daß die Korrekturbedingungen "Winkelkorrektur negativ" lautet.

Das Resultat wird in Figur 2F dargestellt, in der der Vergleichs-Vektor 20 mit dem bisherigen Betrag unter dem in negativer Richtung korrigierten Winkel von rund 16,88° dargestellt ist. Das dadurch erzeugte neue Unter-Koordinatensystem zeigt, daß sich die Spitze des Momentan-Vektors 21 im unteren linken Feld befindet und gemäß der Tabelle nun der Betrag um einen Schritt negativ korrigiert werden muß. Der Vollzug dieser Korrektur wurde zeichnerisch nicht mehr dargestellt, da schon aus der Darstellung in Figur 2F erkennbar ist, daß sich beim nächsten Schritt die Vektoren bereits fast decken würden.

Die schrittweise Annäherung erfolgt - wie gezeigt - über die Sinus- und Cosinuswerte des Vergleichswinkels aus der eingangs genannten Tabelle. Der Betrag kann alternativ über einen als zusätzlichen Digital-/Analog-Wandler ausgebildeten Betragsteller schrittweise angepaßt werden, in dem die Referenzspannungen der beiden anderen Digital-/Analogwander 13 und 14 varriert werden.

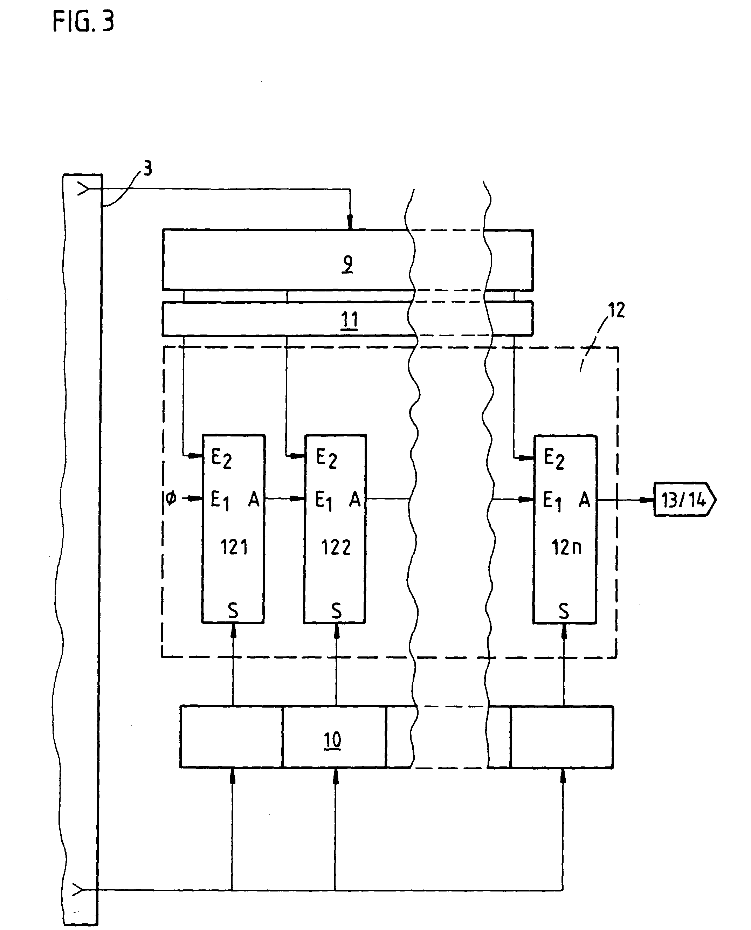

In Figur 3 ist ein Betragsteller 12 dargestellt, der in besonders vorteilhafter Weise als Digitalschaltung ausgebildet ist. Gezeigt ist der Zweig für das Sinussignal, in gleicher Weise ist der digitale Betragsteller 12 für den Cosinuszweig ausgebildet, so daß in der Beschreibung gleichwertig von Sinus/Cosinus geschrieben wird.

Für Sinus und Cosinus ist je eine Serienschaltung von Addierern 121 bis 12n vorgesehen. Die Anzahl der Addierer 121 bis 12n entspricht der Auflösung im Betrag. Jeder Addierer 121 bis 12n hat zwei Eingänge E1, E2, einen Ausgang A, sowie einen Steuereingang S. Abhängig vom Steuereingang S liegt am Ausgang A entweder der Wert des Einganges E1 oder die Summe E1+E2. Die Ausgänge A sind jeweils mit den Eingängen E1 der nachfolgenden Addierer verbunden. Der Eingang E1 des ersten Addierers 121 ist mit Null verbunden, der Ausgang des n-ten Addierers führt zum DA-Wandler 13/14. Die Eingänge E2 der Addierer 121 bis 12n, sind mit dem Ausgang der Sinus/Cosinus Tabelle 11 verbunden. Dabei wird dem ersten Addierer 121 der vollständige Sinus/Cosinuswert zugeführt; die nachfolgenden Addierer 122 bis 12n erhalten jeweils um ein bit "nach rechts, verschobene" d.h. jeweils halbierte Sinus-/Cosinuswerte. Die Steuereingänge S sind mit dem Betragsregister 10 verbunden. Somit ist es möglich, durch Ansteuerung des Winkel 9- und Betragsregisters 10 jeden möglichen Vergleichs-Vektor 20 innerhalb des ersten Quadranten I einzustellen. Das Verfahren ist in allen vier Quadranten anwendbar, wobei in Figur 1 nicht gezeichnete Einrichtungen zur Umkehrung des Vorzeichens und Addition eines Offsetwertes benötigt werden. Die Steuerlogik 3 führt den oben beschriebenen Approximationsalgorithmus aus. Dabei bewirkt sie abhängig vom Quadranten und den logischen Zuständen der Komparatoren 6 und 7 eine Korrektur im Betrag oder Winkel des Vergleichs-Vektors 20. Je nach Ergebnis des Vergleichs werden Winkel oder Betrag des Vergleichs-Vektors 20 um die Hälfte des vorhergehenden Schrittes korrigiert. Diese schrittweise Annäherung wird fortgesetzt, bis eine ausreichende Genauigkeit vorliegt. Dabei muß für die Verdoppelung der Genauigkeit mit zwei Arbeitszyklen gerechnet werden. Nach Erreichen eines bestimmten Abschlußkriteriums stehen die Amplituden und Winkelwerte in den entsprechenden Registern zur Verfügung. Als Abbruchkriterium kann die mitgezählte Anzahl von Winkelkorrekturen gelten.

## Patentansprüche

1. Vorrichtung (1) zur Unterteilung von analogen periodischen Signalen, insbesondere von zueinander phasenverschobenen Meßsignalen einer Längen- oder Winkelmeßeinrichtung mit Hilfe einer Interpolationsschaltung, dadurch gekennzeichnet, daß durch momentane Analogwerte der zueinander phasenverschobenen Meßsignale (sin, cos) ein Momentan-Vektor(21) gebildet wird und daß die Analogwerte jeweils einem Komparator (6, 7) zugeführt werden, daß zum Erzeugen eines nach Winkel und Betrag veränderbaren Vergleichs-Vektors (20) ein Vektor-Generator (2) vorgesehen ist, daß analogisierte Werte des Vergleichs-Vektors (20) in Form von Referenzspannungen (X, Y) den vorgenannten Komparatoren (6, 7) zugeführt werden, und daß in Abhängigkeit vom Vergleichsergebnis der Analogwerte von Momentan (21)- und Vergleichs-Vektor (20) eine Steuerlogik (3) aufgrund eines Algorithmus mit Hilfe des Vektor-Generators (2) eine schrittweise Annäherung des Vergleichs-Vektors (20) an den Momentan-Vektor (21) bewirkt, und daß bei hinreichender Annäherung von dem Vektor-Generator (2) die entsprechenden Interpolations- und Amplitudenwerte über Ausgangsleitungen (15, 16) ausgegeben werden.

2. Vorrichtung nach Anspruch 1, dadurch gekennzeichnet, daß der Vektor-Generator (2) wenigstens eine trigonometrische Wertetabelle (11), ein Betrags (10)- und ein Winkelregister (9), einen Betragsteller (12) sowie mehrere Digital-/Analogwandler(13, 14) aufweist.

3. Vorrichtung nach Anspruch 2, dadurch gekennzeichnet, daß der Betragsteller (12) durch einen Digital-/Analog-Wandler gebildet wird, der mit Hilfe des Betragsregisters (10) Referenzspannungen der Digital-/Analogwandler (13, 14) variiert.

4. Vorrichtung nach Anspruch 2, dadurch gekennzeichnet, daß der Betragsteller (12) durch eine Digitalschaltung gebildet wird.

5. Vorrichtung nach Anspruch 4, dadurch gekennzeichnet, daß der Betragsteller (12) jeweils für Sinus und Cosinus eine der gewünschten Auflösung entsprechende Anzahl von Addierern (121 bis 12n) aufweist, die eine Serienschaltung bilden, wobei die Ausgänge (A) der Addierer (121 bis 12n-1) jeweils mit den Eingängen (E1) der nachfolgenden Addierer (122 bis 12n) verbunden sind.

6. Vorrichtung nach Anspruch 5, dadurch gekennzeichnet, daß Eingänge(E2) der Addierer (121 bis 12n) mit der trigonometrischen Wertetabelle (11) verbunden sind.

7. Vorrichtung nach Anspruch 2 und Anspruch 6, dadurch gekennzeichnet, daß die trigonometrische Wertetabelle (11) eine Sinus/Cosinus Tabelle ist.

8. Vorrichtung nach Anspruch 7, dadurch gekennzeichnet, daß dem ersten Addierer (121) vollständige Sinus-/Cosinuswerte zugeführt werden und daß die nachfolgenden Addierer (122 bis 12n) jeweils halbierte Sinus-/Cosinuswerte erhalten.

9. Vorrichtung nach Anspruch 5, dadurch gekennzeichnet, daß die Addierer (121 bis 12n) über Steuereingänge mit dem Betragsregister (10) verbunden sind.

## Claims

1. Device (1) for subdividing periodical analog signals, especially of measuring signals, out of phase with one another, of a length or angle measuring device with the aid of an interpolation circuit, **characterised in that** a temporary vector (21) is formed by temporary analog values of measuring signals (sin, cos) and in that the analog values are in each case lead into a comparator (6, 7), in that a vector generator (2) is provided for creating a comparison vector (20) adjustable according to angle and quantity, in that values, converted to analog, of the comparison vector (20) in the form of reference voltages (X, Y) are led into the above-mentioned comparators (6, 7), and that, in dependence on the result of the comparison of the analog values of the temporary (21) and comparison (20) vectors, a control logic system (3) effects, on the basis of an algorithm with the aid of the vector generator (2), a successive approximation of the comparison vector (20) to the temporary vector (21) and that with adequate approximation from the vector generator (2) the corresponding interpolation and amplitude values are output via outgoing circuits (15, 16).

2. Device according to claim 1, **characterised in that** the vector generator (2) has at least a trigonometric value table (11), a quantity register (10) and an angle register (9), a quantity setting means (12) as well as a plurality of digital-analog converters (13, 14).

3. Device according to claim 2, **characterised in that** the quantity setting means (12) is formed by a digital-analog converter which varies reference voltages of the digital-analog converters (13, 14) with the aid of the quantity register (10).

4. Device according to claim 2, **characterised in that** the quantity setting means (12) is formed by a digital circuit.

5. Device according to claim 4, **characterised in that** the quantity setting means (12) for sine and cosine in each case has a number of adders (121 to 12n) corresponding to the desired resolution, which adders form a series circuit, the outputs (A) of the adders (121 to 12n-1) being each connected with the inputs (E1) of the succeeding adders (122 to 12n).

6. Device according to claim 5, **characterised in that** inputs (E2) of the adders (121 to 12n) are connected with the trigonometric value table (11).

7. Device according to claim 2 and claim 6, **characterised in that** the trigonometric value table (11) is a sine/cosine table.

8. Device according to claim 7, **characterised in that** complete sine/cosine values are led into the first adder (121) and the succeeding adders (122 to 12n) in each case receive halved sine/cosine values.

9. Device according to claim 5, **characterised in that** the adders (121 to 12n) are connected with the quantity register (10) via control inputs.

## Revendications

1. Dispositif (1) pour la subdivision de signaux périodiques analogiques, notamment de signaux de mesure mutuellement déphasés de dispositifs de mesure de longueurs ou d'angles, au moyen d'un circuit d'interpolation, caractérisé par le fait que l'on forme un vecteur instantané (21) à l'aide de valeurs analogiques instantanées des signaux de mesure (sin, cos) mutuellement déphasés et que l'on transmet les valeurs analogiques chaque fois à un comparateur (6, 7), par le fait qu'il est prévu un générateur de vecteur (2) pour générer un vecteur de référence (20) dont l'angle et la valeur sont variables, par le fait que des valeurs amenées sous une forme analogique du vecteur de référence (20) sont transmises aux comparateurs (6, 7) mentionnés, sous la forme de tensions de référence (X, Y) et que, en fonction du résultat de la comparaison des valeurs analogiques pour le vecteur instantané (21) et pour le vecteur de référence (20), une unité logique de commande (3) déclenche sur la base d'un algorithme, à l'aide du générateur de vecteur (2), un rapprochement graduel du vecteur de référence (20) du vecteur instantané (21) et par le fait, que lorsque le rapprochement est suffisant, le générateur de vecteur (2) délivre les valeurs correspondantes d'interpolation et d'amplitude par l'intermédiaire de lignes de sortie (15, 16).

2. Dispositif selon la revendication 1, caractérisé par le fait que le générateur de vecteur (2) comporte au moins une table (11) de valeurs trigonométriques, un registre de valeurs (10) et un registre d'angles (9), un circuit de valeur absolue (12) ainsi que plusieurs convertisseurs numérique/analogique (13, 14).

3. Dispositif selon la revendication 2, caractérisé par le fait que le circuit de valeur absolue (12) est formé d'un convertisseur numérique/analogique qui, à l'aide du registre de valeurs (10), fait varier des tensions de référence des convertisseurs numérique/analogique (13, 14).

4. Dispositif selon la revendication 2, caractérisé par le fait que le circuit de valeur absolue (12) est formé d'un circuit numérique.

5. Dispositif selon la revendication 4, caractérisé par le fait que le circuit de valeur absolue (12) présente respectivement pour sinus et pour cosinus un nombre d'additionneurs (121 à 12n) qui est fonction de la résolution souhaitée, qui forment un circuit série, les sorties (A) des additionneurs (121 à 12n-1) étant connectées chaque fois aux entrées (E1) des additionneurs (122 à 12n) suivants.

6. Dispositif selon la revendication 5, caractérisé par le fait que les entrées (E2) des additionneurs (121 à 12n) sont reliées à la table (11) de valeurs trigonométriques.

7. Dispositif selon la revendication 5 et la revendication 6, caractérisé par le fait que la table (11) de valeurs trigonométriques est une table sinus/cosinus.

8. Dispositif selon la revendication 7, caractérisé par le fait que l'on envoie au premier additionneur (121) des valeurs sinus/cosinus entières et que les additionneurs suivants (122 à 12n) reçoivent chaque fois des demi valeurs sinus/cosinus.

9. Dispositif selon la revendication 5, caractérisé par le fait que les additionneurs (121 à 12n) sont reliés au registre de valeurs (10) par des entrées de commande.
